# EUROPÄISCHE PATENTSCHRIFT

(11) **EP 1 905 287 B1**
(45) Veröffentlichungstag und Bekanntmachung des Hinweises auf die Patenterteilung: **27.03.2019**
(21) Anmeldenummer: 06775718.7
(22) Anmeldetag: 20.07.2006
(51) Int. Cl.: H01L 33/48, H01L 33/44, H01L 33/46

(54) **GEHÄUSE FÜR EIN ELEKTROMAGNETISCHE STRAHLUNG EMITTIERENDES OPTOELEKTRONISCHES BAUELEMENT, ELEKTROMAGNETISCHE STRAHLUNG EMITTIERENDES BAUELEMENT UND VERFAHREN ZUM HERSTELLEN EINES GEHÄUSES ODER EINES BAUELEMENTS**
HOUSING FOR AN OPTOELECTRONIC COMPONENT EMITTING ELECTROMAGNETIC RADIATION, COMPONENT EMITTING ELECTROMAGNETIC RADIATION, AND METHOD FOR THE PRODUCTION OF A HOUSING OR A COMPONENT
BOITIER POUR COMPOSANT OPTOÉLECTRONIQUE ÉMETTANT DU RAYONNEMENT ÉLECTROMAGNÉTIQUE, COMPOSANT ÉMETTANT DU RAYONNEMENT ÉLECTROMAGNÉTIQUE, ET PROCÉDÉ POUR RÉALISER UN BOITIER OU UN COMPOSANT DE CE TYPE

(30) Priorität: 21.07.2005 DE 102005034166
(43) Veröffentlichungstag der Anmeldung: 02.04.2008
(73) Patentinhaber: OSRAM Opto Semiconductors GmbH, 93055 Regensburg (DE)
(72) Erfinder: ENGL, Moritz, 93055 Regensburg (DE); OSWALD, Florin, 6240 Rattenberg (AT)
(74) Vertreter: Epping - Hermann - Fischer
(86) Internationale Anmeldenummer: PCT/DE2006/001261
(87) Internationale Veröffentlichungsnummer: WO 2007/009447

(56) Entgegenhaltungen:
- EP-A- 1 189 291
- DE-A1- 10 032 839
- DE-A1- 19 536 451
- DE-A1- 19 600 678
- US-A1- 2004 061 433

## Beschreibung

Die Erfindung betrifft ein Gehäuse für ein optoelektronisches Bauelement, das geeignet ist, bei dessen Betrieb eine elektromagnetische Strahlung zu emittieren. Sie umfasst zudem ein elektromagnetische Strahlung emittierendes Bauelement mit einem derartigen Gehäuse sowie ein Verfahren zum Herstellen eines derartigen Gehäuses oder Bauelements.

Es sind Gehäuse für elektromagnetische Strahlung emittierende optoelektronische Bauelemente mit einem Grundkörper bekannt, der eine Ausnehmung definiert. Der Boden dieser Ausnehmung ist für eine Montage eines Lumineszenzdiodenchips vorgesehen. Die Innenwände der Ausnehmung können in der Art eines Reflektors geformt sein, sodass ein Teil einer von dem Lumineszenzdiodenchip emittierten elektromagnetische Strahlung mittels der Innenwände in einen gewünschten Abstrahl-Raumwinkel umgelenkt werden kann.

Der Grundkörper für derartige Gehäuse besteht in vielen Fällen aus einem Kunststoff. Zudem sind beispielsweise auch Gehäuse bekannt, bei denen der Grundkörper teilweise oder vollständig aus einem keramischen Material besteht.

Optoelektronische Bauelemente, die eine elektromagnetische Strahlung emittieren, finden immer häufiger in Scheinwerfer- oder Projektionsapplikationen Anwendung. Ein Beispiel für einen Scheinwerfer, in dem elektromagnetische Strahlung emittierende Lumineszenzdioden verwendet werden, ist in der WO 2004/088200 angegeben. Die in dieser Druckschrift angegebenen Scheinwerferelemente sind beispielsweise auch für Projektionsapplikationen verwendbar. DE 100 32 839 offenbart ein Gehäuse für ein elektromagnetische Strahlung emittierendes optoelektronisches Bauelement mit den im ersten Teil des Anspruchs 1 genannten Merkmalen.

Bei Scheinwerfer- oder Projektionsapplikationen ist es wichtig, eine von Lumineszenzdiodenchips emittierte elektromagnetische Strahlung mit einer möglichst hohen Strahlungsdichte in einen vorgegebenen, engen Raumwinkel abzustrahlen. Dazu werden zum Beispiel Strahlenkegel mittels Optiken wie Projektionslinsen auf eine gewünschte Ebene projiziert. Bei derartigen Anwendungen können Unregelmäßigkeiten in der Abstrahlcharakteristik verwendeter optoelektronischer Bauelemente verstärkt werden und somit besonders stark ins Gewicht fallen. Von daher gibt es einen Bedarf an entsprechenden Bauelementen, die hinsichtlich ihrer Abstrahleigenschaften speziell für derartige Anwendungen ausgebildet sind.

Eine zu lösende Aufgabe besteht darin, ein Gehäuse der eingangs genannten Art anzugeben, das durch technisch einfache Maßnahmen bezüglich erzielbarer Abstrahlcharakteristiken gegenüber bekannten Gehäusen verbessert ist. Das Gehäuse soll insbesondere besser für Scheinwerfer- und/oder Projektionsapplikationen geeignet sein. Zudem soll ein Bauelement mit einem derartigen Gehäuse und ein Verfahren zum Herstellen eines derartigen Gehäuses angegeben werden.

Es wird ein Gehäuse der eingangs genannten Art angegeben, das äußere Seitenflächen aufweist, die zumindest teilweise mit einer Abschirmschicht versehen sind. Die Abschirmschicht ist geeignet, eine elektromagnetische Strahlung abzuschirmen, wobei insbesondere vorgesehen ist, eine im Inneren des Gehäuses erzeugte oder zu erzeugende elektromagnetische Strahlung nach außen abzuschirmen. Dadurch kann bei entsprechenden optoelektronischen Bauelementen mit einem derartigen Gehäuse vorteilhafterweise ein seitlicher Austritt elektromagnetischer Strahlung aus dem Gehäuse deutlich verringert oder vollständig vermieden werden.

Bei herkömmlichen elektromagnetische Strahlung emittierenden Bauelementen wurde festgestellt, dass Gehäusekörper, die einen Kunststoff und/oder ein keramisches Material aufweisen, oft teildurchlässig für die elektromagnetische Strahlung sind. Insbesondere bei Gehäuse mit dünnen Gehäusewänden werden diese von einem Teil der im Inneren des Gehäuses erzeugten elektromagnetischen Strahlung durchdrungen. Somit wird die elektromagnetische Strahlung nicht nur in einen bevorzugten Raumwinkel, sondern auch seitlich aus dem Gehäuse abgestrahlt.

Eine derartige seitlich abgestrahlte elektromagnetische Strahlung ist für viele Anwendungen nicht störend, da sie lediglich einen geringen Anteil an der insgesamt aus dem Gehäuse emittierten Strahlungsintensität ausmacht. Es wurde jedoch festgestellt, dass sich die seitlich emittierte elektromagnetische Strahlung insbesondere bei Scheinwerfer- und Projektionsapplikationen als störend auswirken kann. Dies ist beispielsweise bei Applikationen der Fall, bei denen ein Strahlenkegel mit einer wohldefinierten Leuchtdichteverteilung und scharfen Hell/Dunkel-Übergängen erzielt werden soll.

Mit der Maßnahme, äußere Seitenflächen des Gehäuses mit einer Abschirmschicht zu versehen, wird ein technisch einfaches und effizientes Mittel angegeben, um die Abstrahlcharakteristik derartiger Gehäuse zu verbessern. Das Aufbringen einer Abschirmschicht auf äußere Seitenflächen des Gehäuses erfordert vorteilhafterweise grundsätzlich kein spezielles Gehäusedesign, sondern es kann bei vielen herkömmlichen Gehäusen durchgeführt werden.

Unter äußeren Seitenflächen des Gehäuses sind Außenflächen eines Gehäusekörpers des Gehäuses zu verstehen, die von einer für ein Bauelement mit dem Gehäuse vorgesehenen Abstrahlachse abgeneigt sind. Die Abstrahlachse verläuft insbesondere senkrecht zu einer Chipmontageebene oder einer Gehäusemontageebene des Gehäuses sowie durch einen Bereich, der für einen Lumineszenzdiodenchip wie beispielsweise eine Leuchtdiode vorgesehen ist. Außenflächen, deren Haupterstreckungsebene sich senkrecht zu der Abstrahlachse erstreckt oder zu der Abstrahlachse hingeneigt ist, sind keine äußeren Seitenflächen. Auch rückseitige Außenflächen, die von einer Abstrahlseite des Gehäuses abgewandt sind, fallen bevorzugt ebenfalls nicht unter den Ausdruck "äußere Seitenflächen".

Die äußeren Seitenflächen können teilweise oder vollständig eben ausgebildet sein. Es ist alternativ oder zusätzlich auch möglich, dass die äußeren Seitenflächen konkav oder konvex gekrümmt oder in irgendeiner Art strukturiert sind.

Die Abschirmschicht ist insbesondere dazu geeignet, eine elektromagnetische Strahlung abzuschirmen, die einen Spektralbereich einer von einem Lumineszenzdiodenchip emittierten elektromagnetischen Strahlung umfasst, wobei der Lumineszenzdiodenchip für ein Bauelement mit dem Gehäuse vorgesehen ist. Besonders bevorzugt ist die Abschirmschicht geeignet, eine elektromagnetische Strahlung vollständig abzuschirmen, das heißt die Abschirmschicht ist besonders bevorzugt undurchlässig für eine elektromagnetische Strahlung eines abzuschirmenden Wellenlängenbereiches. Es ist jedoch auch möglich, dass die Abschirmschicht auch teilweise durchlässig für elektromagnetische Strahlung ist. Beispielsweise kann sie für elektromagnetische Strahlung eines nicht notwendigerweise abzuschirmenden Wellenlängenbereiches oder auch für eine abzuschirmende elektromagnetische Strahlung teilweise durchlässig sein. Die abzuschirmende elektromagnetische Strahlung ist bevorzugt sichtbares Licht.

Bevorzugt weist die Abschirmschicht für einen abzuschirmenden Wellenlängenbereich einer elektromagnetischen Strahlung, die von einer für das Bauelement mit dem Gehäuse vorgesehenen Lumineszenzdiode emittiert wird, einen Gesamttransmissionsgrad von kleiner als oder gleich 0,1, besonders bevorzugt von kleiner als oder gleich 0,05 auf. Mit besonderem Vorteil ist dieser Gesamttransmissionsgrad zumindest für den sichtbaren Anteil der Strahlung ungefähr 0.

Unter dem Begriff "Abschirmschicht" fallen vorliegend keine elektrischen Anschlussleiter oder elektrische Leiterbahnen des Gehäuses. Vielmehr ist das Gehäuse auf den äußeren Seitenflächen entweder frei von elektrischen Leiterbahnen oder elektrischen Anschlussleitern oder das Gehäuse weist an den äußeren Seitenflächen zusätzlich zu etwaigen vorhandenen elektrischen Anschlussleitern oder elektrischen Leiterbahnen mindestens eine Abschirmschicht auf.

Gemäß einer vorteilhaften Ausführungsform weist die Abschirmschicht ein für die elektromagnetische Strahlung reflektierendes Material auf. Dadurch kann die elektromagnetische Strahlung von den äußeren Seitenflächen in einen Gehäusekörper zurückreflektiert werden und ist somit nicht notwendigerweise für eine Nutzung verloren.

Zusätzlich oder alternativ weist die Abschirmschicht mit Vorteil ein für die elektromagnetische Strahlung absorbierendes Material auf. Geeignete absorbierende Materialien können mit Vorteil besonders kostengünstig sein und die elektromagnetische Strahlung mit hoher Effizienz abschirmen. Besonders bevorzugt umfasst das absorbierende Material ein schwarzes Material, das heißt die Farbe des Materials ist für das menschliche Auge als ein Schwarzton wahrnehmbar.

Gemäß einer zweckmäßigen Ausführungsform weist die Abschirmschicht einen Lack auf. Lacke sind kostengünstige Materialien, die sich auf technisch einfache Weise auftragen lassen.

Zweckmäßigerweise umfassen die äußeren Seitenflächen Außenflächen eines Gehäusekörpers, der keramisches Material aufweist. Zusätzlich oder alternativ umfassen die äußeren Seitenflächen Außenflächen eines Gehäusekörpers, der gemäß einer weiteren zweckmäßigen Ausführungsform mindestens einen Kunststoff aufweist. Kunststoffe und keramische Materialien, wie sie für herkömmliche optoelektronische Gehäuse verwendet werden, sind oftmals durchlässig für elektromagnetische Strahlung wie beispielsweise sichtbares Licht. Von daher ist es besonders zweckmäßig, derartige Gehäuse mit der Abschirmschicht zu versehen.

Die äußeren Seitenflächen des Gehäuses sind mit besonderem Vorteil gegenüber einer senkrecht zu einer Montageebene des Gehäuses verlaufenden Ebene zumindest teilweise geneigt. Die äußeren Seitenflächen sind insbesondere derart geneigt, dass sie zumindest teilweise von der Montageebene des Gehäuses abgewandt sind. Dies kann für ein Aufbringen der Abschirmschicht vorteilhaft sein, da die geneigten Teile der äußeren Seitenflächen nicht senkrecht zu der Montageebene des Gehäuses verlaufen und somit nicht nur seitlich, sondern auch von oben zugänglich sind. Unter einer Oberseite des Gehäuses ist vor allem eine von einer Montageebene des Gehäuses abgewandte Seite zu verstehen.

Besonders bevorzugt sind die äußeren Seitenflächen gegenüber der Ebene zumindest teilweise zwischen einschließlich 30° und einschließlich 60° geneigt.

Mit Vorteil ist zumindest eine äußere Seitenfläche im Wesentlichen vollständig mit der Abschirmschicht bedeckt. Unter einer Seitenfläche ist in diesem Zusammenhang die Oberfläche eines Gehäusekörpers auf einer seiner Hauptseiten zu verstehen. Beispielsweise weist ein Gehäusekörper mit einer im Wesentlichen quadratischen oder rechteckförmigen Grundform vier seitliche Hauptseiten auf. Die Außenfläche auf mindestens einer der Hauptseiten ist gemäß dieser Ausführungsform im Wesentlichen vollständig mit der Abschirmschicht bedeckt.

Es wird weiterhin ein Gehäuse angegeben, bei dem die Abschirmschicht mit Vorteil Kunststoff aufweist oder aus Kunststoff besteht. Kunststoffe können mit Vorteil absorbierende Eigenschaften aufweisen und sich beispielsweise in Form einer Beschichtung aufbringen lassen.

Das elektromagnetische Strahlung emittierende optoelektronische Bauelement umfasst das Gehäuse und mindestens eine Lumineszenzdiode, beispielsweise in Form eines Lumineszenzdiodenchips, die in dem Gehäuse montiert ist.

Es wird ein Verfahren zum Herstellen eines Gehäuses für ein optoelektronisches Bauelement oder eines elektromagnetische Strahlung emittierenden Bauelements angegeben. Ein Verfahrensschritt umfasst das Bereitstellen eines Gehäuses oder eines Bauelements mit einem Gehäuse. Ein weiterer Verfahrensschritt beinhaltet das Aufbringen einer Abschirmschicht auf zumindest einen Teil von äußeren, seitlich angeordneten Oberflächen des Gehäuses, das heißt auf zumindest einen Teil von äußeren Seitenflächen des Gehäuses.

Besonders bevorzugt umfasst das Aufbringen der Abschirmschicht die Verwendung von Tampondruck. Der Tampondruck ist ein indirektes Druckverfahren, das insbesondere zum Bedrucken von Kunststoffkörpern geeignet ist. Mittels eines Tampondrucks lassen sich auch unebene, beispielsweise konvex oder konkav gewölbte Flächen mit einem aufzubringenden Material versehen.

Zusätzlich oder alternativ kann das Aufbringen der Abschirmschicht die Verwendung von mindestens einem der Methoden Siebdruck, Tintenstrahldruck, Kunststoffbeschichtung und Pulverbeschichtung umfassen.

Weitere Vorteile, bevorzugte Ausführungsformen und Weiterbildungen des Gehäuses, des Bauelements und des Verfahrens ergeben sich aus dem im Folgenden in Verbindung mit den Figuren 1 bis 13 erläuterten Ausführungsbeispielen. Es zeigen:
- Figuren 1 bis 3: verschiedene schematische perspektivische Darstellungen eines Gehäuses gemäß eines ersten Ausführungsbeispiels,
- Figuren 4 und 5: verschiedene schematische perspektivische Darstellungen eines Gehäuses gemäß eines zweiten Ausführungsbeispiels,
- Figur 6: eine schematische perspektivische Darstellung eines Bauelements gemäß eines ersten Ausführungsbeispiels und eines Gehäuses gemäß eines dritten Ausführungsbeispiels,
- Figur 7: eine schematische perspektivische Darstellung eines Bauelements gemäß eines zweiten Ausführungsbeispiels eines Gehäuses gemäß eines vierten Ausführungsbeispiels,
- Figur 8: eine schematische perspektivische Darstellung eines Gehäuses gemäß eines fünften Ausführungsbeispiels,
- Figur 9: eine schematische perspektivische Darstellung eines Leuchtmoduls mit einem Bauelement gemäß eines dritten Ausführungsbeispiels und einem Gehäuse gemäß eines sechsten Ausführungsbeispiels,
- Figur 10: eine schematische Schnittansicht eines Bauelements "gemäß eines vierten Ausführungsbeispiels und eines Gehäuses gemäß eines siebten Ausführungsbeispiels, und
- Figuren 11 bis 13: schematische Schnittansichten verschiedener Verfahrensstadien eines Ausführungsbeispiels des Verfahrens.

In den Ausführungsbeispielen und Figuren sind gleiche oder gleich wirkende Bestandteile jeweils mit den gleichen Bezugszeichen versehen. Die dargestellten Bestandteile sowie die Größenverhältnisse der Bestandteile untereinander sind nicht notwendigerweise als maßstabsgerecht anzusehen. Vielmehr können einige Details der Figuren zum besseren Verständnis übertrüben groß dargestellt sein. Dies gilt insbesondere für die beispielhaften Darstellungen der Abschirmschicht.

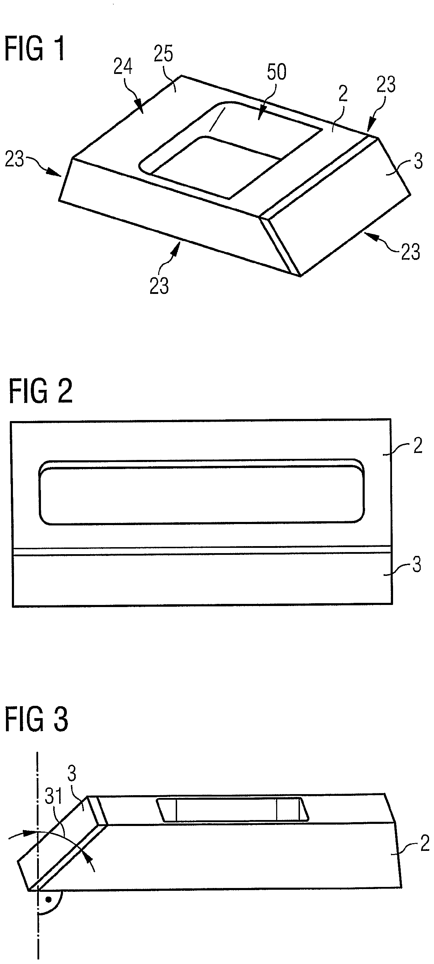

Das in den Figuren 1 bis 3 dargestellte Gehäuse 2 weist einen Gehäusekörper 25 mit einer Kavität 50 auf. Die Öffnung der Kavität 50 weist eine lang gestreckte Querschnittsfläche auf, die beispielsweise in der Art eines Rechteckes mit verrundeten Kanten ausgebildet ist. Die Kavität 50 ist dafür vorgesehen, in ihr mindestens einen Lumineszenzdiodenchip zu montieren und elektrisch leitend anzuschließen. Das in den Figuren 1 bis 3 dargestellte Gehäuse ist beispielsweise für vier oder fünf Lumineszenzdiodenchips vorgesehen, die an einem Boden der Kavität 50 zum Beispiel in einer linienförmigen Anordnung montiert werden.

Der Gehäusekörper 25 weist beispielsweise ein Kunststoffmaterial auf oder besteht aus einem solchen. Vorzugsweise wird hierfür ein thermoplastischer oder duroplastischer Kunststoff verwendet, beispielsweise Polyphtalamid. Dem Kunststoffmaterial können Füllstoffe zugesetzt sein. Geeignete Füllstoffe sind beispielsweise Bariumsulfat, Anatas (dies ist eine Modifikation von TiO₂) und Polytetrafluorethylen (PTFE, beispielsweise Teflon), die vorzugsweise mit einem Volumenanteil bis zu 50 % zugesetzt sind. Ein weiterhin bevorzugter Volumenanteil liegt im Bereich zwischen etwa 5 % und etwa 15 %.

Das Gehäuse 2 weist eine vorderseitig angeordnete Außenfläche 24 des Gehäusekörpers 25 auf, die sich senkrecht zu einer für ein Bauelement vorgesehenen Hauptabstrahlrichtung des Gehäuses erstreckt. Zudem weist der Gehäusekörper 4 äußere Seitenflächen 23 auf. Eine dieser äußeren Seitenflächen 23 ist mit einer Abschirmschicht 3 versehen.

In dem in den Figuren 1 bis 3 dargestellten Ausführungsbeispiel bedeckt die Abschirmschicht 3 die eine äußere Seitenfläche vollständig. Es ist jedoch auch möglich, dass diese äußere Seitenfläche 23 nur teilweise von der Abschirmschicht 3 bedeckt ist. Beispielsweise kann nur eine obere Hälfte mit der Abschirmschicht 3 versehen sein.

Die mit der Abschirmschicht 3 versehene äußere Seitenfläche 23 ist gegenüber einer senkrecht zu einer Montageebene des Gehäuses verlaufenden Ebene geneigt. Die Seitenfläche ist eben ausgebildet und gegenüber der Ebene um einen Winkel 31 gekippt, siehe Figur 3. Der Winkel 31 beträgt zwischen einschließlich 30° und einschließlich 60°, beispielsweise 50°.

Die Abschirmschicht 3 besteht beispielsweise aus einem reflektierenden Material, das zum Beispiel metallisches Material wie Silber aufweist. Zum Ausbilden der Abschirmschicht ist z.B. eine Silberschicht mit einer ausreichend hohen Schichtdicke auf der entsprechenden äußeren Seitenfläche 23 aufgebracht. Silber weist für einen großen Spektralbereich sichtbaren Lichts eine hohe Reflektivität auf. Um eine vollständige Abschirmung zu erzielen, darf die Silberschicht nicht lediglich wenige Monolagen dick sein, da sie sonst teilweise für elektromagnetische Strahlung durchlässig ist. Sie weist beispielsweise eine Dicke von 10 µm auf.

Zusätzlich oder alternativ kann die Abschirmschicht 3 beispielsweise auch absorbierendes Material aufweisen. Hierfür kommt zum Beispiel ebenfalls metallisches Material in Frage, das für einen vorgesehenen Spektralbereich überwiegend absorbierende Eigenschaften aufweist. Auch bei dem absorbierenden Material ist es wichtig, dieses nicht in einer zu dünnen Schicht aufzutragen, damit eine im Inneren des Gehäuses erzeugte elektromagnetische Strahlung weitestgehend abgeschirmt werden kann. Die Abschirmschicht weist für einen abzuschirmenden Wellenlängenbereich beispielsweise einen Gesamttransmissionsgrad von kleiner als oder gleich 0,01 auf. Als absorbierendes Material kommen beispielsweise auch Lacke oder Kunststoffe in Frage.

Die Abschirmschicht 3 weist gemäß einer weiteren beispielhaften Ausführungsform eine reflektierende Schicht auf, die auf der entsprechenden äußeren Seitenfläche 23 aufgebracht ist und auf der wiederum eine absorbierende Schicht aufgebracht ist. Die absorbierende Schicht ist beispielsweise ein schwarzer Lack oder ein schwarzer Kunststoff. Diese sind insbesondere für sichtbare elektromagnetische Strahlung absorbierend. Die Abschirmschicht 3 kann alternativ beispielsweise auch nur aus einer ausreichend dicken schwarzen Lackschicht oder schwarzen Kunststoffschicht bestehen.

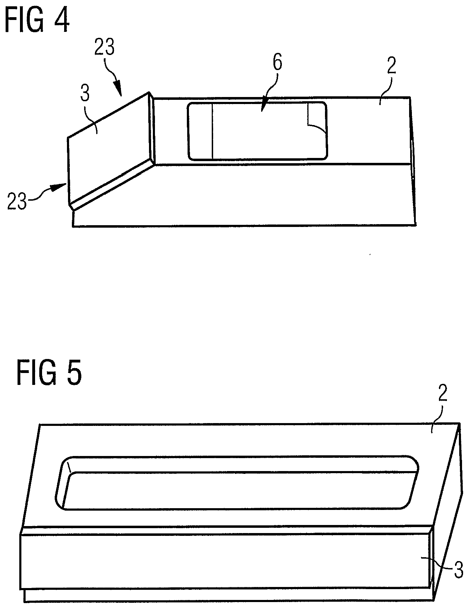

Bei dem in den Figuren 4 und 5 dargestellten Gehäuse 2 ist im Unterschied zu dem vorhergehend anhand der Figuren 1 bis 3 beschriebenen Gehäuse eine äußere Seitenfläche 23 nur teilweise mit einer Abschirmschicht 3 bedeckt. Die teilweise mit der Abschirmschicht 3 bedeckte äußere Seitenfläche 23 weist einen ersten und einen zweiten Teil auf. Beide Teile sind beispielsweise eben ausgebildet. Der erste Teil verläuft zum Beispiel senkrecht gegenüber einer Montageebene des Gehäuses 2. Der zweite Teil ist gegenüber dem ersten Teil geneigt, beispielsweise um 55°. Dieser zweite Teil ist zum Beispiel vollständig mit der Abschirmschicht 3 bedeckt. Der erste Teil ist frei von der Abschirmschicht. Alternativ kann auch der erste Teil mit der Abschirmschicht bedeckt sein.

Im übrigen kann das in den Figuren 4 und 5 dargestellte Gehäuse 2 wie das vorhergehend anhand der Figuren 1 bis 3 dargestellte Gehäuse ausgebildet sein. Das gleiche gilt für mögliche Zusammensetzungen, Materialien und Aufbauten der Abschirmschicht 3.

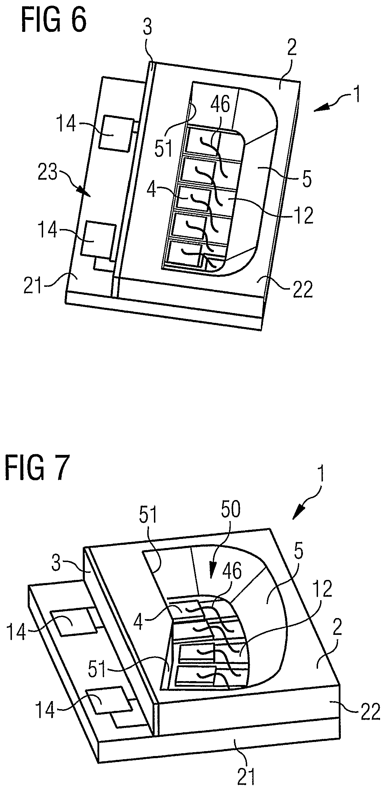

Die in den Figuren 6 und 7 dargestellten Bauelemente weisen ein Gehäuse 2 mit einem Träger 21 und einem auf dem Träger 21 angeordneten Rahmen 22 auf. Der Rahmen 22 weist Innenwände 5 auf, die eine Kavität 50 begrenzen. In der grabenartig ausgebildeten Kavität 50 ist eine Mehrzahl von Halbleiterchips 4 in einer linienförmigen Anordnung angeordnet.

Bei dem in Figur 6 dargestellten Bauelement sind die Lumineszenzdiodenchips 4 entlang einer Geraden angeordnet. Im Unterschied dazu sind die Lumineszenzdiodenchips 4 bei dem in Figur 7 dargestellten Bauelement teilweise entlang einer ersten Gerade und teilweise entlang einer zweiten Gerade angeordnet, wobei die erste und die zweite Gerade miteinander einen Winkel von beispielsweise 15° einschließen. Die Anordnung der Halbleiterchips weist somit einen Knick auf.

Die Innenwände 5 der Kavität 50 weisen einen relativ geringen Abstand zu den Lumineszenzdiodenchips 4 auf. Der Abstand ist beispielsweise kleiner als oder gleich einer lateralen Kantenlänge der Lumineszenzdiodenchips 4. Entsprechend weist der Boden der Kavität 50 eine relativ geringe Fläche auf.

Die Lumineszenzdiodenchips 4 sind in dem Gehäuse 2 elektrisch montiert, wobei sie beispielsweise in Serie zueinander geschaltet sind. Hierzu weist der Boden der Kavität 50 eine Mehrzahl von inneren elektrischen Kontaktflächen 12 auf, wobei die Lumineszenzdiodenchips z.B. auf ihrer dem Boden 54 der Kavität 50 zugewandten Seite z.B. mittels Löten oder Leitkleber elektrisch leitend mit den entsprechenden inneren Kontaktflächen 12 verbunden sind und auf einem Teil der jeweiligen Kontaktfläche 12 aufliegen. Eine von den inneren Kontaktflächen 12 abgewandte Seite der Lumineszenzdiodenchips 4 ist z.B. mittels eines Bonddrahtes 46 mit der entsprechenden Kontaktfläche elektrisch leitend verbunden Zwei der inneren Kontaktflächen 12 erstrecken sich auf dem Träger 21 bis zu einem Bereich des Trägers 21, der lateral zu dem Rahmen 22 versetzt ist, wo sie elektrisch leitend mit Außenkontakten 14 des Bauelements 1 elektrisch leitend verbunden sind, über die das Bauelement 1 extern elektrisch angeschlossen werden kann.

Die Lumineszenzdiodenchips 4 emittieren bei ihrem Betrieb z.B. eine elektromagnetische Strahlung aus einem blauen oder ultravioletten Wellenlängenbereich.

Beispielsweise weist der Rahmen Aluminiumoxid auf oder besteht aus diesem. Alternativ ist es auch möglich, dass der Rahmen ein weniger gut reflektierendes Material, wie z.B. Aluminiumnitrid oder ein Flüssigkristallpolymer (LCP), aufweist oder aus diesem besteht. Die Verwendung von LCP als ein Material für den Rahmen 22 hat den Vorteil, dass sich das Material thermisch an den Träger 21 anpassen lässt. Der Träger 21 weist als Material z.B. Aluminiumnitrid auf, welches kostengünstig ist und eine hohe Wärmeleitfähigkeit aufweist. Als alternative Materialien sind beispielsweise auch Silizium oder Siliziumcarbid möglich.

Das Gehäuse 2 der in den Figuren 6 und 7 dargestellten Bauelemente 1 weist auf einer Seite entlang der Anordnung der Lumineszenzdiodenchips 4 eine die Kavität 50 begrenzende Innenwand auf, wobei zumindest ein Abschnitt der Innenwand als eine Blendenwand 51 ausgebildet ist. Durch eine derartige Blendenwand kann die Emission der Strahlung in einen unerwünschten Raumbereich unterdrückt werden. Hierzu verläuft die Blendenwand 51 zweckmäßigerweise im wesentlichen in einem Winkel von größer als oder gleich 80° und kleiner als oder gleich 110° zu einer Montageebene der Lumineszenzdiodenchips 4. Insbesondere verläuft die Blendenwand im wesentlichen senkrecht zu der Montageebene.

Die Lumineszenzdiodenchips 4 sind in einem Abstand 53 von beispielsweise kleiner als oder gleich 100 µm zu der Blendenwand 51 angeordnet. Bei einem derart geringen Abstand 53 kann eine effektive Blendenwirkung der Blendenwand 51 auch dann erreicht werden, wenn die Blendenwand 51 relativ niedrig ausgebildet ist, d.h. wenn sie eine geringe Höhe aufweist. Zudem trifft durch diesen geringen Abstand ein Teil der von den Lumineszenzdiodenchips 4 emittierten elektromagnetischen Strahlung mit einer hohen Strahlungsintensität pro Fläche auf die Blendenwand 51, wodurch sowohl die Vermeidung von Strahlung in einem unerwünschten Raumwinkel als auch das Abstrahlen der elektromagnetischen Strahlung in einen gewünschten, bevorzugt engen Raumwinkel und mit einer hohen Strahlungsdichte weitgehend ermöglicht wird.

Diese Eigenschaften sind insbesondere bei Scheinwerfern, beispielsweise bei Autoscheinwerfern erwünscht, durch die ein bestimmter Raumwinkel möglichst hell ausgeleuchtet werden soll. Bei Autoscheinwerfern soll beispielsweise einerseits der Fahrtweg, d.h. insbesondere die Straße möglichst hell ausgeleuchtet werden, andererseits dürfen jedoch entgegenkommende Fahrzeuge nicht geblendet werden, so dass eine Abstrahlung von Licht in den oberen Raumwinkel unerwünscht und weitestgehend vermeiden ist. Eben dies kann durch ein Bauelement mit einer Blendenwand 51 erreicht werden. Zudem ermöglicht die gestreckte Anordnung der Lumineszenzdiodenchips 4 eine helle und flächige, homogene Ausleuchtung des Weges bzw. der Straße über die gesamte Breite der Straße hinweg.

Diejenige äußere Seitenfläche 23 des Rahmens 21, die der Blendenwand 51 gegenüber liegt, ist bei den in den Figuren 6 und 7 dargestellten Bauelementen 1 jeweils mit einer Abschirmschicht 3 versehen. Diese kann wie vorhergehend bereits beschrieben ausgebildet sein. Durch die Abschirmschicht 3 ist eine Vermeidung von Strahlungsemission in einen unerwünschten Raumwinkel weitergehend realisierbar.

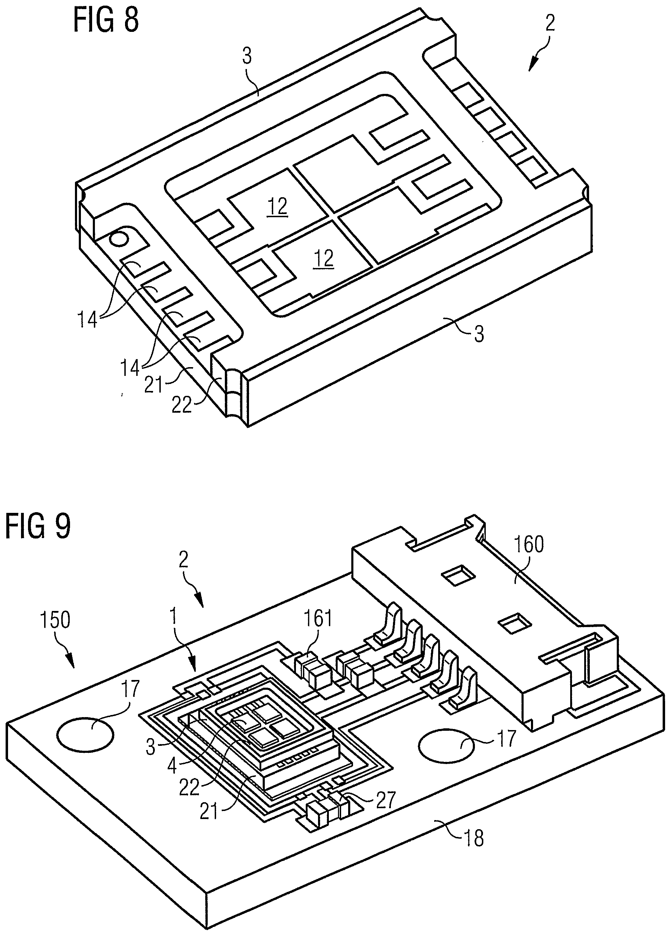

Das in Figur 8 dargestellte Gehäuse 2 weist ebenfalls einen Träger 21 und einen Rahmen 22 auf. Das Gehäuse 2 weist auf zwei einander gegenüber liegenden Seiten elektrische Außenkontaktflächen 14 auf, die elektrisch leitend mit inneren elektrischen Kontaktflächen 12 verbunden sind. Das Gehäuse 2 ist für eine Anzahl n von Lumineszenzdiodenchips vorgesehen und weist 2 * n Außenkontaktflächen 14 auf, so dass es möglich ist, jeden in einem solchen Gehäuse 2 montierten Lumineszenzdiodenchip unabhängig von den anderen Lumineszenzdiodenchips anzusteuern. Die Außenkontaktflächen 14, elektrischen Kontaktflächen 12 und Leiterbahnen zwischen diesen Kontaktflächen sind beispielsweise mittels Metallbeschichtungen auf dem Träger 21 ausgebildet. Ein geeignetes Metall ist beispielsweise Gold.

An denjenigen Seiten, an denen keine Außenkontaktflächen 14 ausgebildet sind, sind die äußeren Seitenflächen 23 des Gehäuses 2 jeweils mit einer Abschirmschicht 3 versehen. Die Abschirmschicht 3 erstreckt sich sowohl über äußere Seitenflächen 23 des Trägers 21 als auch des Rahmens 22. Rahmen und Träger weisen beispielsweise ein keramisches Material wie zum Beispiel Aluminiumnitrid auf oder bestehen aus einem solchen.

In Figur 9 ist ein Leuchtmodul 150 dargestellt, das ein einziges Bauelement 1 aufweist. Das Bauelement 1 hat derart geringe Abmessungen, dass es vorteilhafterweise auf eine vielfache Art eingesetzt werden und technisch einfach montiert werden kann.

Das Leuchtmodul 150 weist einen Modulträger 18 auf, in den zwei Löcher 17 eingebracht sind. Die Löcher 17 dienen zur mechanischen Montage und alternativ oder zusätzlich auch zum thermischen Anschließen des Leuchtmoduls 150. Beispielsweise kann das Leuchtmodul 150 mit den Löchern 17 über einen oder zwei Montagestifte mit oder ohne Gewinde gesteckt und mit Klemmen oder Schrauben befestigt werden.

Bei dem in Figur 9 dargestellten Leuchtmodul 150 ist ein Gegenstecker 160 enthalten, so dass es mittels eines entsprechenden Steckers extern elektrisch kontaktiert werden kann. Zudem weist das Leuchtmodul 150 zum Beispiel einen Überspannungsschutz für die Lumineszenzdiodenchips 4 auf. Ein solcher ist beispielsweise in Form von mindestens einem Varistor 161 vorgesehen, der zu dem Bauelement 1 oder zu Lumineszenzdiodenchips 4 parallel geschaltet ist.

Das in dem Leuchtmodul 150 enthaltene Bauelement 1 ist ähnlich wie das vorhergehend anhand Figur 8 erläuterte Bauelement 1 aufgebaut. Es weist einen Träger 21, einen Rahmen 22 und vier Lumineszenzdiodenchips 4 auf. Der Rahmen 22 ist an allen seinen äußeren Seitenflächen rundherum mit einer Abschirmschicht 3 versehen. Dagegen ist der Träger 21 zum Beispiel frei von einer Abschirmschicht. Alternativ kann das Leuchtmodul selbstverständlich auch ein anderes Bauelement aufweisen, das z.B. ein Gehäuse 2 wie vorhergehend anhand der Figuren 1 bis 8 beispielhaft beschrieben aufweist.

Die beschriebenen Gehäuse 2 und Bauelemente 1 können insbesondere für ein Scheinwerfermodul, insbesondere auch für Automobilanwendungen, verwendet werden. Ebenso können sie für Projektionsanwendungen geeignet sein.

Die Bauelemente 1 emittieren zum Beispiel weißes Licht, wofür sie beispielsweise ein Lumineszenzkonversionselement aufweisen, das die von den Lumineszenzdiodenchips 4 emittierte Strahlung eines ersten Wellenlängenbereiches zumindest teilweise in eine Strahlung eines zweiten, von dem ersten Wellenlängenbereich unterschiedlichen Wellenlängenbereiches konvertiert. Weißes Licht kann entweder erzeugt werden, indem die von dem Lumineszenzdiodenchip emittierte Strahlung mit der konvertierten Strahlung gemischt wird oder indem die konvertierte Strahlung Farbanteile aufweist, die zusammengemischt weißes Licht ergeben.

Das Lumineszenzkonversionsmaterial kann mindestens einen Leuchtstoff enthalten. Dazu eignen sich beispielsweise anorganische Leuchtstoffe, wie mit seltenen Erden (insbesondere Ce) dotierte Granate, oder organische Leuchtstoffe, wie Perylen-Leuchtstoffe. Weitere geeignete Leuchtstoffe sind beispielsweise in der WO 98/12757 aufgeführt, deren Inhalt insofern hiermit durch Rückbezug aufgenommen wird.

Die Lumineszenzdiodenchips 4 können entweder mit einer Vergussmasse vergossen sein, die beispielsweise auf Silikon basiert, oder mit einer strahlungsdurchlässigen Abdeckplatte abgedeckt sein, wodurch sie vor äußeren Einflüssen geschützt sind.

Durch den Aufbau des Gehäuses 2 mit einem Träger 21 und einem Rahmen 22 sowie mit auf dem Träger 21 aufgebrachten Kontaktflächen 12, 14 ist eine einfache Herstellung des Bauelements 1 möglich, bei der z.B. ein aufwendiges Erzeugen von Durchkontaktierungen nicht erforderlich ist. Alternativ kann der Gehäusekörper jedoch auch einstückig ausgebildet sein, beispielsweise durch Umspritzen eines Leadframes, das die jeweiligen Kontakte für die Lumineszenzdiodenchips 4 und das Bauelement 1 umfasst.

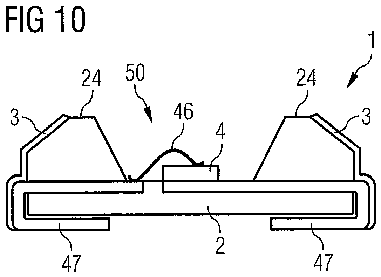

Ein Beispiel für derartiges Gehäuse mit einem Leadframe 47 ist in Figur 10 dargestellt. Es weist z.B. einen einzigen Lumineszenzdiodenchip 4 auf, der elektrisch leitend an zwei elektrischen Anschlussleitern des Leadframes 47 angeschlossen ist. Das Leadframe 47 ist mittels einer Spritzmasse oder Gussmasse, die Kunststoff umfasst, mit einem Gehäusekörper umformt.

Alle äußeren Seitenflächen des Gehäuses 2 sind mit einer Abschirmschicht 3 versehen, wobei sich diese z.B. auch über Teile des Leadframes erstrecken.

Die Lumineszenzdiodenchips 4 sind beispielsweise Leuchtdiodenchips, bevorzugt sind es Dünnfilm-Leuchtdiodenchips.

Ein Dünnfilm-Leuchtdiodenchip zeichnet sich insbesondere durch folgende charakteristische Merkmale aus:
- an einer zu einem Trägerelement hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20µm oder weniger, insbesondere im Bereich von 10 µm auf; und
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug aufgenommen wird.

Ein Dünnfilm-Leuchtdiodenchip ist in guter Näherung ein Lambert'scher Oberflächenstrahler und eignet sich von daher besonders gut für die Anwendung in dem Bauelement, insbesondere für einen Scheinwerfer.

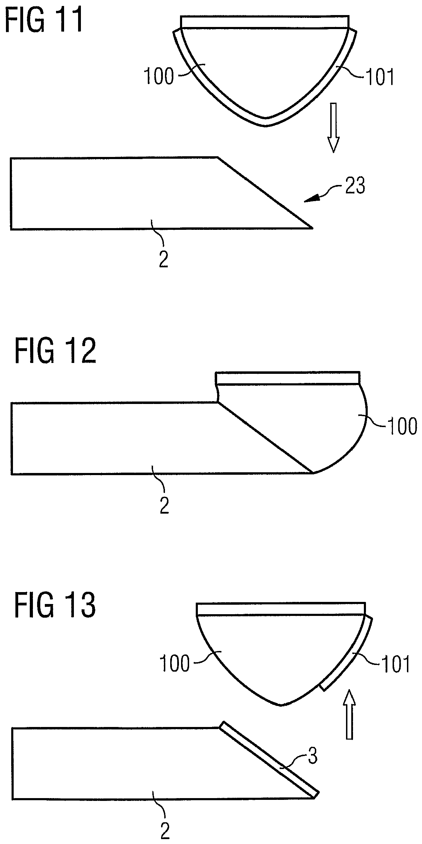

Bei den vorhergehend beschriebenen Ausführungsbeispielen kann zumindest ein Teil der Abschirmschicht 3 oder die gesamte Abschirmschicht 3 mittels Tampondruck aufgebracht werden. Verschiedene Verfahrensstadien eines beispielhaften derartigen Verfahrens sind in den Figuren 11 bis 13 dargestellt.

Ein Tampon 100 wird mit einem Abschirmmaterial 101 versehen. Hierzu wird der Tampon beispielsweise auf eine Vorrichtung, auf der das Abschirmmaterial aufgebracht ist, aufgedrückt. Derartige Vorrichtungen nennt man Druckstock oder Klischee. Der Tampon 100 besteht aus einem hochelastischen Material, das beispielsweise einen Kautschuk aufweist oder aus einem solchen besteht. Besonders geeignet ist Silikonkautschuk.

In Figur 11 ist ein Tampon 100 dargestellt, der mit einem Abschirmmaterial 101 wie beispielsweise schwarzer Farbe benetzt ist. Der Tampon 100 wird nach unten auf eine schräg verlaufende äußere Seitenfläche 23 eines Gehäuses 2 geführt. Die Bewegungsrichtung des Tampons 100, die in Figur 11 durch einen Pfeil angeordnet ist, verläuft senkrecht zu einer Montageebene des Gehäuses 2. Die zu bedruckende äußere Seitenfläche 23 ist also um einen Winkel von kleiner als 90°, beispielsweise 45°, gegenüber der Richtung geneigt, entlang der der Tampon 100 auf das Gehäuse 2 geführt wird.

Wenn der Tampon 100 gegen das Gehäuse 2 gedrückt wird, verformt er sich und passt sich dem schrägen Verlauf der zu bedruckenden äußeren Seitenfläche 23 an, siehe Figur 12.

Nachfolgend wird der Tampon 100 wieder vom Gehäuse 2 weggeführt, was in Figur 13 wiederum durch einen Pfeil angedeutet ist. Dasjenige Abschirmmaterial, das beim Aufdrücken des Tampons mit der zu bedruckenden äußeren Seitenfläche 23 mit dieser in Berührung kommt, bleibt am Gehäuse 2 haften und bildet zumindest einen Teil einer Abschirmschicht 3, siehe Figur 13.

Diese Verfahrensschritte können je nach Bedarf beliebig oft wiederholt werden. Es können mittels derartigen Verfahrensschritten auch beispielsweise nacheinander unterschiedliche Abschirmmaterialien auf äußeren Seitenflächen des Gehäuses 2 aufgebracht werden. Selbstverständlich ist es möglich, alle äußeren Seitenflächen vollständig mittels Tampondruck mit einem oder mehreren Abschirmmaterialien 101 zu bedecken.

Alternativ oder zusätzlich zum Tampon-Druck kann die Abschirmschicht auch zumindest teilweise mittels Siebdruck aufgebracht werden. Hierzu wird z.B. ein Sieb oder eine Maske auf eine äußere Seitenfläche des Gehäuses aufgebracht, auf das nachfolgend ein Abschirmmaterial aufgetragen wird. Das Abschirmmaterial ist weist eine für Siebdruck geeignete Viskosität auf. Es kann z.B. einen schwarzen Lack oder sonstige schwarze Farbe umfassen. Mittels einer Rakel wird das Abschirmmaterial in Aussparungen des Siebes oder der Maske auf der äußeren Seitenfläche verteilt.

Als weiteres alternatives oder ergänzendes Verfahren ist z.B. auch Tintenstrahldruck zum Aufbringen von Abschirmmaterial geeignet. Insbesondere absorbierende Farbe, z.B. schwarze Farbe kann auf diese Weise aufgebracht werden. Hierzu wird z.B. ein herkömmlicher CIJ-Drucker ("Continous Ink Jet"-Drucker) verwendet. Die Verwendung eine DOD-Druckers ("Drop on demand"-Drucker) ist ebenso möglich.

Insbesondere Metallschichten können zusätzlich oder alternativ zu den vorhergehend beschriebenen Verfahren beispielsweise mittels Aufdampfen, Aufsputtern oder Aufkleben aufgebracht werden.

Weiterhin ist z.B. auch Kunststoffbeschichtung zum Aufbringen von Abschirmmaterial geeignet.

Sowohl Metallschichten als auch Kunststoffschichten lassen sich zusätzlich oder alternativ auch beispielsweise mittels Pulver-Beschichtung aufbringen. Es kann z.B. eine elektrostatische Pulverbeschichtung oder eine andersartige Pulverbeschichtung verwendet werden. Das Abschirmmaterial wird hierbei in Form eines Pulvers aufgetragen. Dieses wird nachfolgend erhitzt, wodurch es sich zu einer beispielsweise einstückigen Schicht verbindet und an der Oberfläche, auf die es aufgetragen wurde, haften bleibt.

## Patentansprüche

1. Gehäuse (2) für ein elektromagnetische Strahlung emittierendes optoelektronisches Bauelement, wobei äußere Seitenflächen (23) des Gehäuses (2) zumindest teilweise mit einer Abschirmschicht (3) versehen sind, die geeignet ist, eine elektromagnetische Strahlung abzuschirmen, wobei die äußeren Seitenflächen (23) gegenüber einer senkrecht zu einer Montageebene des Gehäuses (2) verlaufenden Ebene zumindest teilweise geneigt sind,
**dadurch gekennzeichnet, dass**
- die Abschirmschicht (3) ein für die elektromagnetische Strahlung absorbierendes Material aufweist, und
- alle äußeren Seitenflächen (23) des Gehäuses (2) mit der Abschirmschicht (3) versehen sind, sodass ein seitlicher Austritt elektromagnetischer Strahlung aus dem Gehäuse (2) verringert oder vollständig vermieden ist.

2. Gehäuse nach Anspruch 1,
**dadurch gekennzeichnet, dass**
eine reflektierende Schicht zumindest auf einer der äußeren Seitenflächen (23) angeordnet ist und auf der reflektierenden Schicht wiederum die Abschirmschicht (3) mit dem absorbierenden Material angeordnet ist.

3. Gehäuse nach einem der vorhergehenden Ansprüche,
**dadurch gekennzeichnet, dass**
das Gehäuse (2) einen Gehäusekörper aufweist, der von einem Leadframe mit zwei elektrischen Anschlussleitern umformt ist, wobei sich die Abschirmschicht (3) über Teile des Leadframes erstreckt.

4. Gehäuse nach Anspruch 3,
**dadurch gekennzeichnet, dass**
die Abschirmschicht ein schwarzes Material aufweist.

5. Gehäuse nach einem der vorhergehenden Ansprüche,
**dadurch gekennzeichnet, dass**
die Abschirmschicht einen Lack aufweist.

6. Gehäuse nach einem der vorhergehenden Ansprüche,
**dadurch gekennzeichnet, dass**
die äußeren Seitenflächen Außenflächen eines Gehäusekörpers umfassen, der keramisches Material aufweist.

7. Gehäuse nach einem der vorhergehenden Ansprüche,
**dadurch gekennzeichnet, dass**
die äußeren Seitenflächen Außenflächen eines Gehäusekörpers umfassen, der Kunststoff aufweist.

8. Gehäuse nach einem der vorhergehenden Ansprüche,
**dadurch gekennzeichnet, dass**
die äußeren Seitenflächen gegenüber der Ebene zumindest teilweise zwischen einschließlich 30° und einschließlich 60° geneigt sind.

9. Gehäuse nach einem der vorhergehenden Ansprüche,
**dadurch gekennzeichnet, dass**
zumindest eine äußere Seitenfläche im Wesentlichen vollständig mit der Abschirmschicht bedeckt ist.

10. Gehäuse nach einem der vorhergehenden Ansprüche,
**dadurch gekennzeichnet, dass**
die Abschirmschicht Kunststoff aufweist oder aus Kunststoff besteht.

11. Elektromagnetische Strahlung emittierendes Bauelement (1) mit mindestens einer Lumineszenzdiode (4),
**dadurch gekennzeichnet, dass**
es ein Gehäuse (2) gemäß einem der Ansprüche 1 bis 10 aufweist.

12. Verfahren zum Herstellen eines Gehäuses (2) für eine elektromagnetische Strahlung emittierendes optoelektronisches Bauelement (1) oder eines elektromagnetische Strahlung emittierenden Bauelements (1) mit folgenden Verfahrensschritten:
- Bereitstellen eines Gehäuses (2) oder eines Bauelements (1) mit einem Gehäuse (2), und
- Aufbringen einer Abschirmschicht (3) auf zumindest einen Teil von äußeren Seitenflächen (23) des Gehäuses (2), wobei die äußeren Seitenflächen (23) gegenüber einer senkrecht zu einer Montageebene des Gehäuses (2) verlaufenden Ebene zumindest teilweise geneigt sind,
**dadurch gekennzeichnet, dass**
- die Abschirmschicht (3) ein für die elektromagnetische Strahlung absorbierendes Material aufweist, und
- alle äußeren Seitenflächen (23) des Gehäuses (2) mit der Abschirmschicht (3) versehen sind, sodass ein seitlicher Austritt elektromagnetischer Strahlung aus dem Gehäuse (2) verringert oder vollständig vermieden ist.

13. Verfahren nach Anspruch 12,
**dadurch gekennzeichnet, dass**
das Aufbringen der Abschirmschicht die Verwendung von Tampondruck umfasst.

14. Verfahren nach Anspruch 12 oder 13,
**dadurch gekennzeichnet, dass**
das Aufbringen der Abschirmschicht die Verwendung von Siebdruck umfasst.

15. Verfahren nach einem der Ansprüche 12 bis 14,
**dadurch gekennzeichnet, dass**
das Aufbringen der Abschirmschicht die Verwendung von Tintenstrahldruck umfasst.

16. Verfahren nach einem der Ansprüche 12 bis 15,
**dadurch gekennzeichnet, dass**
das Aufbringen der Abschirmschicht die Verwendung von Kunststoffbeschichtung umfasst.

17. Verfahren nach einem der Ansprüche 12 bis 16,
**dadurch gekennzeichnet, dass**
das Aufbringen der Abschirmschicht die Verwendung von Pulverbeschichtung umfasst.

## Claims

1. Housing (2) for an electromagnetic-radiation-emitting optoelectronic component, wherein
exterior side faces (23) of the housing (2) are at least partly provided with a screening layer (3) suitable for screening an electromagnetic radiation, wherein the exterior side faces (23) are at least partially inclined with respect to a plane extending perpendicularly to a mounting plane of the housing (2),
**characterized in that**
- the screening layer (3) has a material that is absorbent for the electromagnetic radiation, and
- all exterior side faces (23) of the housing (2) are provided with the screening layer (3), so that a lateral emergence of electromagnetic radiation from the housing (2) is reduced or completely avoided.

2. Housing according to Claim 1,
**characterized in that**
a relective layer is arranged on at least one of the exterior side faces (23) and the screening layer (3) comprising the absorbent material is in turn arranged on the reflective layer.

3. Housing according to one of the preceding claims,
**characterized in that**
the housing (2) comprises a housing body surrounded by a leadframe having two electrical connection conductors, wherein the screening layer (3) extends over portions of the leadframe.

4. Housing according to Claim 3,
**characterized in that**
the screening layer has a black material.

5. Housing according to one of the preceding claims,
**characterized in that**
the screening layer has a lacquer.

6. Housing according to one of the preceding claims,
**characterized in that**
the exterior side faces comprise external faces of a housing body which has ceramic material.

7. Housing according to one of the preceding claims,
**characterized in that**
the exterior side faces comprise external faces of a housing body which has plastic material.

8. Housing according to one of the preceding claims,
**characterized in that**
the exterior side faces are inclined with respect to the plane at least partly between 30° and 60° inclusive.

9. Housing according to one of the preceding claims,
**characterized in that**
at least one exterior side face is essentially completely covered with the screening layer.

10. Housing according to one of the preceding claims,
**characterized in that**
the screening layer comprises plastic or consists of plastic.

11. Electromagnetic-radiation-emitting component (1) having at least one luminescence diode (4),
**characterized in that**
it has a housing (2) according to one of Claims 1 to 10.

12. Method for producing a housing (2) for an electromagnetic-radiation-emitting optoelectronic component (1) or an electromagnetic-radiation-emitting component (1) comprising following method steps:
- providing a housing (2) or a component (1) having a housing, and
- applying a screening layer (2) to at least one portion of exterior side faces (23) of the housing (2), wherein the exterior side faces (23) are at least partially inclined with respect to a plane extending perpendicularly to a mounting plane of the housing (2),
**characterized in that**
- the screening layer (3) has a material that is absorbent for the electromagnetic radiation, and
- all exterior side faces (23) of the housing (2) are provided with the screening layer (3), so that a lateral emergence of electromagnetic radiation from the housing (2) is reduced or completely avoided.

13. Method according to Claim 12,
**characterized in that**
applying the screening layer comprises the use of pad printing.

14. Method according to Claim 12 or 13,
**characterized in that**
applying the screening layer comprises the use of screen printing.

15. Method according to one of Claims 12 to 14,
**characterized in that**
applying the screening layer comprises the use of inkjet printing.

16. Method according to one of Claims 12 to 15,
**characterized in that**
applying the screening layer comprises the use of plastic coating.

17. Method according to one of Claims 12 to 16,
**characterized in that**
applying the screening layer comprises the use of powder coating.

## Revendications

1. Boîtier (2) destiné à un composant optoélectronique émettant un rayonnement électromagnétique, sachant que les surfaces latérales externes (23) du boîtier (2) sont dotées au moins partiellement d'une couche de blindage (3) qui convient pour blinder un rayonnement électromagnétique, sachant que les surfaces latérales externes (23) sont inclinées au moins partiellement par rapport à un plan se déroulant à la verticale par rapport à un plan de montage du boîtier (2),
**caractérisé en ce que**
- la couche de blindage (3) présente une matière absorbante pour le rayonnement électromagnétique, et
- toutes les surfaces latérales externes (23) du boîtier (2) sont dotées de la couche de blindage (3), de sorte qu'une sortie latérale de rayonnement électromagnétique hors du boîtier (2) est réduite ou empêchée complètement.

2. Boîtier selon la revendication 1,
**caractérisé**
**en ce qu'**une couche réfléchissante est disposée au moins sur une des surfaces latérales externes (23) et **en ce que** sur la couche réfléchissante est encore disposée la couche de blindage (3) avec la matière absorbante.

3. Boîtier selon une quelconque des revendications précédentes,
**caractérisé**
**en ce que** le boîtier (2) présente un corps de boîtier qui est remodelé par une grille de connexion avec deux conducteurs de raccordement électriques, sachant que la couche de blindage (3) s'étend sur des parties de la grille de connexion.

4. Boîtier selon la revendication 3,
**caractérisé**
**en ce que** la couche de blindage présente une matière noire.

5. Boîtier selon une quelconque des revendications précédentes,
**caractérisé**
**en ce que** la couche de blindage présente un vernis.

6. Boîtier selon une quelconque des revendications précédentes,
**caractérisé**
**en ce que** les surfaces latérales externes comportent des surfaces externes d'un corps de boîtier qui présente de la matière céramique.

7. Boîtier selon une quelconque des revendications précédentes,
**caractérisé**
**en ce que** les surfaces latérales externes comportent des surfaces externes d'un corps de boîtier qui présente du plastique.

8. Boîtier selon une quelconque des revendications précédentes,
**caractérisé**
**en ce que** les surfaces latérales externes sont inclinées par rapport au plan au moins partiellement à entre 30° et 60° inclus.

9. Boîtier selon une quelconque des revendications précédentes,
**caractérisé**
**en ce qu'**au moins une surface latérale externe est recouverte complètement pour l'essentiel de la couche de blindage.

10. Boîtier selon une quelconque des revendications précédentes,
**caractérisé**
**en ce que** la couche de blindage présente du plastique ou se compose de plastique.

11. Composant émettant un rayonnement électromagnétique (1) avec au moins une diode luminescente (4),
**caractérisé**
**en ce qu'**il présente un boîtier (2) selon une quelconque des revendications 1 à 10.

12. Procédé en vue de la fabrication d'un boîtier (2) destiné à un composant optoélectronique émettant un rayonnement électromagnétique (1) ou d'un composant émettant un rayonnement électromagnétique (1) avec les étapes de procédé suivantes:
- mise à disposition d'un boîtier (2) ou d'un composant (1) avec un boîtier (2), et
- application d'une couche de blindage (3) sur au moins une partie des surfaces latérales externes (23) du boîtier (2), sachant que les surfaces latérales externes (23) sont inclinées au moins partiellement par rapport à un plan se déroulant à la verticale par rapport à un plan de montage du boîtier (2),
**caractérisé en ce que**
- la couche de blindage (3) présente une matière absorbante pour le rayonnement électromagnétique, et
- toutes les surfaces latérales externes (23) du boîtier (2) sont dotées de la couche de blindage (3), de sorte qu'une sortie latérale de rayonnement électromagnétique hors du boîtier (2) est réduite ou empêchée complètement.

13. Procédé selon la revendication 12,
**caractérisé**
**en ce que** l'application de la couche de blindage comporte l'utilisation de tampographie.

14. Procédé selon les revendications 12 ou 13,
**caractérisé**
**en ce que** l'application de la couche de blindage comporte l'utilisation de sérigraphie.

15. Procédé selon une quelconque des revendications 12 à 14,
**caractérisé**
**en ce que** l'application de la couche de blindage comporte l'utilisation d'impression à jet d'encre.

16. Procédé selon une quelconque des revendications 12 à 15,
**caractérisé**
**en ce que** l'application de la couche de blindage comporte l'utilisation de revêtement plastique.

17. Procédé selon une quelconque des revendications 12 à 16,
**caractérisé**
**en ce que** l'application de la couche de blindage comporte l'utilisation de revêtement par poudre.
